(19) Europäisches Patentamt / European Patent Office / Office européen des brevets

(11) **EP 2 557 601 B1**

(12) **EUROPEAN PATENT SPECIFICATION**

(45) Date of publication and mention
of the grant of the patent:
**15.06.2016 Bulletin 2016/24**

(21) Application number: **12002327.0**

(22) Date of filing: **30.03.2012**

(51) Int Cl.:
*H01L 31/042* (2006.01)    *H01L 31/048* (2006.01)

(54) **Solar cell module**

Solarzellenmodul

Module de cellule solaire

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.08.2011  KR 20110080269**

(43) Date of publication of application:
**13.02.2013  Bulletin 2013/07**

(73) Proprietor: **LG Electronics Inc.
Yeongdeungpo-gu
Seoul 150-721 (KR)**

(72) Inventor: **Park, Sanghwan
Kyungsangnam-do 641-110 (KR)**

(74) Representative: **Frenkel, Matthias Alexander
Wuesthoff & Wuesthoff
Patentanwälte PartG mbB
Schweigerstrasse 2
81541 München (DE)**

(56) References cited:
**WO-A1-2010/144520     US-A1- 2008 216 889
US-A1- 2008 261 037     US-A1- 2010 175 742**

**Description**

BACKGROUND OF THE INVENTION

1. Field of the Invention

Embodiments of the invention relate to a solar cell module, and more particularly to a solar cell module including a rear substrate having improved reflectivity and reliability.

2. Description of the Related Art

Recently, as it is expected that conventional energy resources such as petroleum and coal will become exhausted in the future, concern for alternative energy resources to replace the conventional energy resources has been gradually increasing. Among them, a solar cell is spotlighted as a new generation cell for directly converting solar energy into electric energy using a semiconductor device.

Meanwhile, since a solar cell must be exposed to external environment to easily absorb solar light, various types of packaging for protecting the solar cell are implemented to fabricate a unit solar cell, referred to as a solar cell module.

Particularly, a rear substrate of the solar cell module is used to protect the solar cell from moisture in the air, and a sealing agent used to seal the solar cell from ultraviolet rays. Thus, the rear substrate needs to be made of a material in which degradation does not occur due to solar light, and have good properties. In addition, in a case of crystalline solar cells, photovoltaic efficiency of the solar cell module may be improved when reflectivity of the substrate increases.

Conventionally, the rear substrate of the solar cell module is manufactured by laminating several films about a base layer. Therefore, additional processes of manufacturing the films separately are needed, whereby reliability of the rear substrate may be deteriorated because an adhesive is used during lamination for adhering the films, and there is also a limitation in increasing the content or amount of pigment used to increase the reflectivity of the rear substrate and in improving dispersibility of the pigment.

Document WO 2010/144520 A1 describes a photovoltaic module comprising encapsulated interconnected solar cells and a backsheet comprising a support substrate coated with a dispersion including a polyvinylidene fluoride (PVDF) to produce a weatherable material. The PVDF coating is exposed to the environment and provides chemical resistance, low water vapor transmission, electrical insulation and UV light protection.

Document US 2010/0175742 A1 describes a photovoltaic module comprising encapsulated interconnected solar cells and a backsheet comprising a functionalized polyvinylidene fluoride (PVDF) composition. The PVDF composition comprises the outermost back layer.

Document US 2008/0216889 A1 describes a solar panel backside film used in solar panel constructions. To create a solar panel backside film, a polymeric layer is adhered to a PET film. The PET film has a net peak area a measured by differential scanning calorimetry of about -15 J/g to about 5 J/g measured from the end point of the glass transition up to 230° C. An additive opacifies the PET film.

SUMMARY OF THE INVENTION

A solar cell module according to claim 1 is provided.

An embodiment of the invention provides a solar cell module including a rear substrate having improved properties such as durability and weatherproof property, high reflectivity, and exhibiting improved photovoltaic efficiency and reliability.

An embodiment of the invention provides a solar cell module including: a front substrate; a rear substrate facing the front substrate; and a plurality of solar cells disposed between the front substrate and the rear substrate; wherein the rear substrate includes a base film including polyethylene terephthalate (PET), and coating layers including polyvinylidene difluoride (PVDF) and formed on upper and lower sides of the base film.

The foregoing and other objects, features, aspects, embodiments and advantages of the invention will become more apparent from the following detailed description of the invention when taken in conjunction with the accompanying drawings.

BRIEF DESCRIPTION OF THE DRAWINGS

FIG 1 is an exploded perspective view of a solar cell module according to an example embodiment of the invention.

FIG. 2 is a side sectional view of the solar cell module of FIG. 1.

FIG. 3 is a sectional view of the solar cell module of FIG 1 taken along line A-A'.

FIG. 4 is a graph illustrating a reflectivity of a rear substrate of the solar cell module of FIG. 1.

FIG. 5 is a graph illustrating UV property of the rear substrate of the solar cell module of FIG. 1.

FIG. 6 depicts views showing results when the rear substrate of the solar cell module is exposed to UV.

FIG. 7 is a graph showing weatherproof property of the rear substrate of the solar cell module of FIG. 1.

FIG. 8 is a graph illustrating reflectivity of rear substrates of experimental examples 1 to 5 not part of the present invention and a comparative example.

DETAILED DESCRIPTION OF THE EMBODIMENTS

The terminology used herein is for the purpose of describing particular embodiments only and is not intended to be limiting of the invention.

Hereinafter, the drawings include reference to elements being all formed, installed, constructed "directly" or "indirectly", "on" or "under" of respective elements, and references to elements being "on" and "under" other elements will be described based on the drawings. The respective elements may be exaggerated, omitted, or schematically illustrated for illustrative convenience.

The invention may be embodied in many different forms and may have various embodiments, of which particular ones will be illustrated in the drawings and will be described in detail the specification. However, it should be understood that the following exemplifying description of the embodiments of invention is not meant to restrict the invention to specific forms of the invention, but rather, the embodiments of the invention are meant to cover all modifications, similarities and alternatives which are included in the scope of the invention.

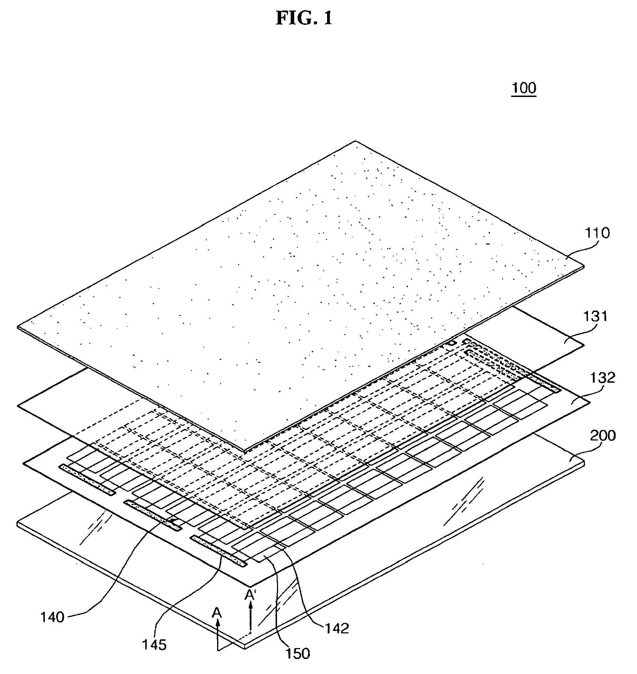

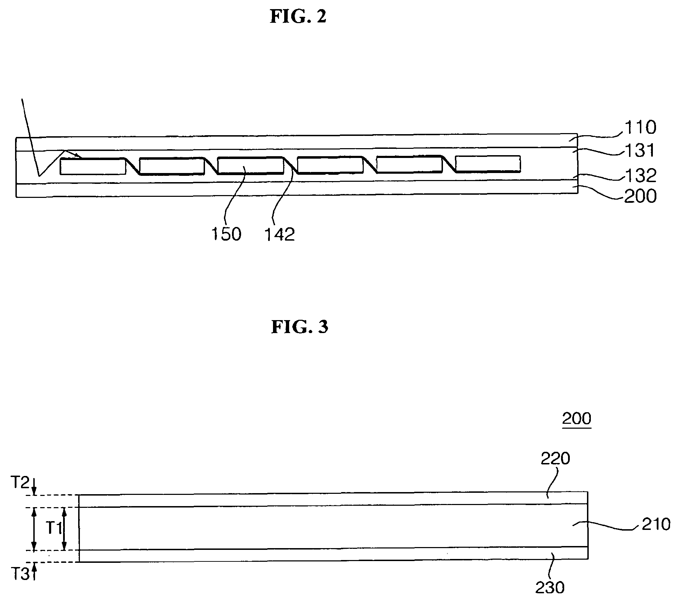

FIG. 1 is an exploded perspective view of a solar cell module according to an example embodiment of the invention. FIG. 2 is a side sectional view of the solar cell module of FIG. 1. FIG. 3 is a sectional view of the solar cell module of FIG. 1 taken along line A-A'.

Referring to the drawings, a solar cell module 100 according to an example embodiment of the invention includes solar cells 150, a front substrate 110 positioned on front sides of the solar cells 150, and a rear substrate 200 positioned on rear sides of the solar cells 150. In addition, the solar cell module 100 further includes a first sealing agent 131 disposed between the solar cells 150 and the front substrate 110 and a second sealing agent 132 disposed between the solar cells 150 and the rear substrate 200.

First, each of the solar cells 150 is a device for converting solar energy into electric energy. Each of the solar cells 150, for example, may be a silicon solar cell including a first conductive type silicon substrate, a second conductive type semiconductor layer, an anti-reflection film, a front electrode, and a rear electrode. The second conductive type semiconductor layer is formed on the silicon substrate and has a conductive type opposite to the first conductive type. The anti-reflection film includes at least one opening for exposing a part of the second conductive type semiconductor layer, and is formed on the second conductive type semiconductor layer. The front electrode comes in contact with a part of the second conductive type semiconductor layer that is exposed through the at least one opening. The rear electrode is formed on the rear side of the silicon substrate. However, embodiments of the invention are not limited thereto and the solar cells 150 may be compound semiconductor solar cells or tandem solar cells in other embodiments of the invention.

The solar cells 150 are electrically connected to each other in series, parallel, or series-and-parallel arrangement by a ribbon or ribbons 142 to form a solar cell string 140.

Specifically, the ribbon 142 may connect the front electrodes formed on a light-receiving surface (or the front side) of one solar cell 150 to the rear electrodes formed on a non-light-receiving surface (or the rear side) of another solar cell 150 adjacent to the one solar cell 140 by way of a tabbing process. The tabbing process may be performed by coating a flux on sides of the solar cells 150, by positioning the ribbons 142 on the solar cells 150 coated with the flux, and by firing or heating the flux and/or the solar cells 150.

Alternatively, the plurality of solar cells 150 may be connected to each other in series or parallel by attaching a conductive film between the sides of the solar cells 150 and the ribbons 142 and by thermally pressing against the ribbons 142. The conductive film includes conductive particles of gold, silver, nickel, and copper with good conductivity that are diffused in a film of epoxy resin, acryl resin, polyimide resin, and/or polycarbonate resin. The conductive particles are exposed to the outside by the thermal pressing, and the solar cells 150 and the ribbons 142 may be electrically connected to each other by the exposed conductive particles. As such, when the plurality of solar cells 150 are connected by the conductive film to form a module, processing temperature can be decreased and bending of the strings 140 can be reduced or prevented.

In addition, bus ribbons 145 connect both ends of the ribbons of the strings 140 alternately to electrically connect the strings 140 of the solar cells. The bus ribbons 145 may be arranged at both ends of the solar cell strings 140 that are arranged in a plurality of columns. In addition, the bus ribbons 145 collect electricity produced by the solar cells 150 and are connected to a junction box for preventing electricity from flowing backward or in a reverse direction.

The first sealing agent 131 may be positioned on the light-receiving surfaces of the solar cells 150 and the second sealing agent 132 may be positioned on the non-light-receiving surfaces of the solar cells 150. The first sealing agent 131 and the second sealing agent 132 are adhered to each other and/or to the solar cells 150 by lamination to block moisture and/or oxygen that would adversely affect the solar cells 150, and to chemically combine respective elements of the solar cells.

The first sealing agent 131 and the second sealing agent 132 may be made of ethylene-vinyl acetate copolymer resin (EVA), polyvinyl butyral, ethylene-vinyl acetate partial oxide, silicon resin, ester-based resin, and olefin-based resin.

The front substrate 110 is positioned on the first sealing agent 131 to allow solar light to pass, and may be a tempered glass for the purpose of protection of the solar cells 150 from external shock. The front substrate 110, in order to reduce or prevent solar light from being reflected and to increase transmission of solar light, and may be a low iron tempered glass containing a low iron content.

The rear substrate 200 is a layer for protecting the other sides (the non-light-receiving surfaces) of the solar cells 150, and for performing water-proofing, insulation, and blocking of ultraviolet rays, and reflects solar light entering the front substrate 110 to be used again.

Referring to FIG. 3, the rear substrate 200 includes a base film 210, a first coating layer 220 and a second coating layer 230 that are formed on an upper side and a lower side of the base film 210, respectively.

First, the base film 210 is made of polyethylene terephthalate (PET). PET is a saturated polyester resin obtained from a reaction between terephthalic acid (HOOC-COOH) and ethylene glycol and has improved heat resistance, insulation, and mechanical strength, and is weatherproof. Particularly, mold shrinkage thereof is about 0.1% to 0.6% and the base film may reduce or prevent the rear substrate 200 from being deformed due to heat.

The base film 210 has a thickness $T_1$ of 250 $\mu$m to 500 $\mu$m. When the thickness $T_1$ of the base film 210 is less than 250 $\mu$m, electric insulation, moisture blocking, and mechanical property would not be sufficient. When the thickness $T_1$ of the base film 210 exceeds 500 $\mu$m, cost may be increased. Particularly, when the thickness $T_1$ of the base film 210 is less than 250 $\mu$m, insulation would not be sufficient for DC voltage of over 1,000V.

The first coating layer 220 and the second coating layer 230 are formed on the upper side and the lower side of the base film 210 respectively.

The first coating layer 220 and the second coating layer 230 include polyvinylidene fluoride (PVDF) and may be made of the same coating. PVDF is polymer having a structure of $(CG_2CF_2)n$ and improved mechanical property, weatherproof property, and ultraviolet resistance because of a double fluoride molecule structure. Therefore, as described below, the rear substrate 200 according to the example embodiment of the invention have improved property.

In addition, the first coating layer 220 and the second coating layer 230 may be made by coating the PVDF resin on the front side and the rear side of the base film 210 using comma, comma reverse, slot die, lip die, and gravure printing. Therefore, a separate process of manufacturing a film and the like for forming the rear substrate 200 may be omitted. Since the first coating layer 220 and the second coating layer 230 may be coated without adhesive for contact with the upper and rear sides of the base film 210, the process of manufacturing the rear substrate 200 becomes simple and the weatherproof property may be improved.

Meanwhile, referring to FIG. 2, some of light that passes through the front substrate is reflected by the rear substrate 200 disposed at the rear side of the solar cells 150. The reflected light is reflected again by an element of the solar cell module 100 and may be absorbed into the solar cells 150. Therefore, in order to improve the efficiency of the solar cell module 100, it is preferable, but not required, that the rear substrate 200 has excellent or improved reflectivity. To this end, according to an embodiment of the invention, at least one of the first coating layer 220 and the second coating layer 230 of the rear substrate 200 includes a pigment.

The pigment may be made of at least one selected from the group consisting of titanium dioxide ($TiO_2$) barium sulfate ($BaSO_4$), barium titanate ($BaTiO_3$), strontium titanate ($SrTiO_3$), calcium titanate ($CaTiO_3$), lead titanate ($PbTiO_3$), tin dioxide ($SnO_2$), magnesium oxide (MgO), aluminum oxide ($Al_2O_3$), silica ($SiO_2$), ferric oxide ($Fe_2O_3$), and zirconia ($ZrO_2$) In one preferred example, a white pigment such as titanium dioxide ($TiO_2$) may be used.

Such a pigment may be dispersed in the PVDF resin and be coated on the upper and lower sides of the base film 210. Accordingly, the pigment can be included in the coating layer 220 and the second coating layer 230. Therefore, dispersibility of pigment may be improved and more quantity of the pigment may be included.

In this instance, the first coating layer 220 and the second coating layer 230 may include different type pigments. For example, the first coating layer 220 may include a white pigment and the second coating layer 230 may include a colorless pigment. Alternatively, only the first coating layer 220 may include the pigment and the second coating layer 230 may not include the pigment. However, embodiments of the invention are not limited thereto and various modifications of using a mixture of the white pigment and the colorless pigment in the first coating layer 220 and the second coating layer 230 are possible.

Since an increased quantity of light is reflected from the first coating layer 220 and a quantity of light is reduced while passing through the first coating layer 220 and the base film 210, a quantity of light reflected from the second coating layer 230 is less than the quantity of light reflected from the first coating layer 220. Therefore, the first coating layer 220 includes the white pigment in order to increase reflectivity, and the second coating layer 230 may include the colorless pigment in order to reduce or prevent ultraviolet damage.

When it is assumed that total weight of the first coating layer 220 (or the second coating layer 230) is 100 parts by weight, the pigment (particularly, the white pigment) is included by 40 to 80 parts by weight. When the pigment is included by less than 40 parts by weight, an effect of improving the reflectivity may not be significant. When a content of the pigment exceeds 80 parts by weight, the content of the pigment is increased so that the first coating layer 220 or the second coating layer 230 may be difficult to be coated. When the content of the pigment is 40 to 80 parts by weight, the reflectivity at wavelengths of 450 nm to 800 nm may be improved to over 85%. When the content of the pigment is 60 to 80 parts by weight, the reflectivity at wavelengths of 450 nm to 800 nm may be improved to over 90%.

In this instance, the contents of the pigments included in the first coating layer 220 and the second coating layer 230 may be different. That is, the first coating layer 220 that is more effective for reflection may have a greater content of the pigment than that of the second coating layer 230.

Meanwhile, PVDF resin may further include a dispersing agent for improving the dispersibility of the pigment. By doing so, the pigments may be dispersed into the first coating layer 220 and the second coating layer 230 more uniformly. In addition, the dispersing agent may reduce viscosity of the PVDF resin so that more pigments can be added, thereby further improving the reflectivity of the rear substrate 200.

A thickness $T_2$ of the first coating layer 220 and a thickness $T_3$ of the second coating layer 230 may be 5 $\mu$m to 50 $\mu$m, and preferably, 20 $\mu$m to 50 $\mu$m. When the thickness $T_2$ of the first coating layer 220 and the thickness $T_3$ of the second coating layer 230 are less than 20 $\mu$m, a property such as the weatherproof property may be deteriorated. Also, the content of the pigment may be not sufficient, and thus, the reflectivity of the rear substrate 220 may be deteriorated. On the contrary, when the thickness $T_2$ of the first coating layer 220 and the thickness $T_3$ of the second coating layer 230 exceed 50 $\mu$m, this may increase manufacturing costs and cause waste of material.

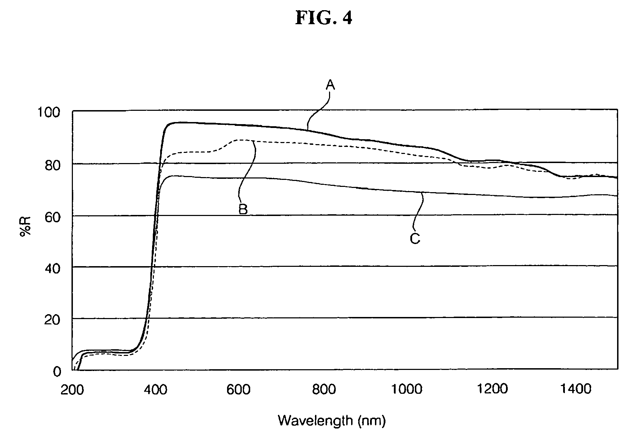

The thickness $T_2$ of the first coating layer 220 and the thickness $T_3$ of the second coating layer 230 is different so that properties of the coating layers may be further improved. That is, since the first coating layer 220 is positioned at a side of the second sealing agent 132, reflectivity and adhesive force may be improved by making the first coating layer 220 to be relatively thicker. The first coating layer 220 has a thickness from 20 to 50 $\mu$m. Thus, even when the second coating layer 230 is relatively thin, it is possible to minimize damage from external moisture and ultraviolet rays. For example, it is sufficient that the second coating layer 230 has a thickness of 5 $\mu$m or more. As such, when the first coating layer 220 is thicker than the second coating layer 230, the reflectivity and adhesive force of the first coating layer 220 may be improved and the thin second coating layer 230 leads to the reduction of costs. FIG. 4 is a graphs illustrating a reflectivity of a rear substrate of the solar cell module of FIG. 1.

In FIG. 4, 'A' indicates the reflectivity of the rear substrate 200 according to an embodiment not part of the invention. In more detail, 'A' indicates the reflectivity of the rear substrate 200 in which the first coating layer 220 and the second coating layer 230

(having a thickness of 20 $\mu$m and including white pigments) are formed on the upper side and the lower side of the base film 210, respectively, and which is made of PET and has a thickness of 250 $\mu$m. 'B' and 'C' indicate the reflectivity of the rear substrate 200 in instances in which adhesive layers are formed on the upper and lower sides of the base film, and in which Tedlar films are attached thereto respectively, whereby 'B' also indicates the reflectivity of the rear substrate made by casting, and 'C' also indicates the reflectivity of the rear substrate made by extrusion.

Referring to FIG. 4, it can be seen that and optical reflectivity of A is better than B and C at wavelengths over 400 nm. In addition, as seen from FIG 4, since the reflectivity of A is 80% or higher against light of wavelengths ranging from 400 nm to 1200 nm, efficiency of the solar cell module 100 including the rear substrate 200 according to an embodiment not part of the invention is improved.

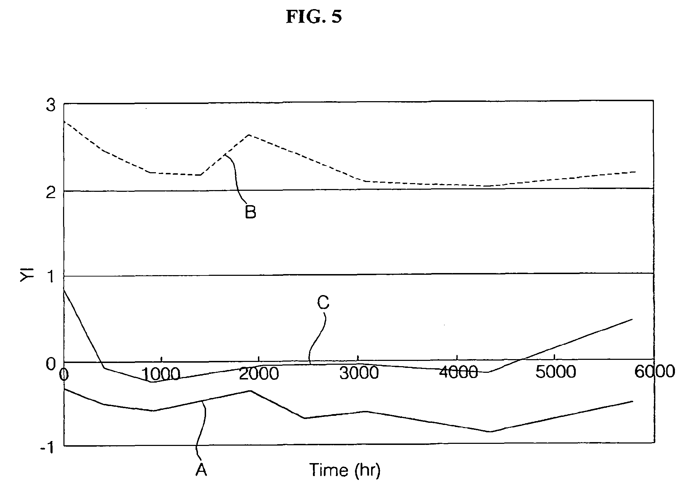

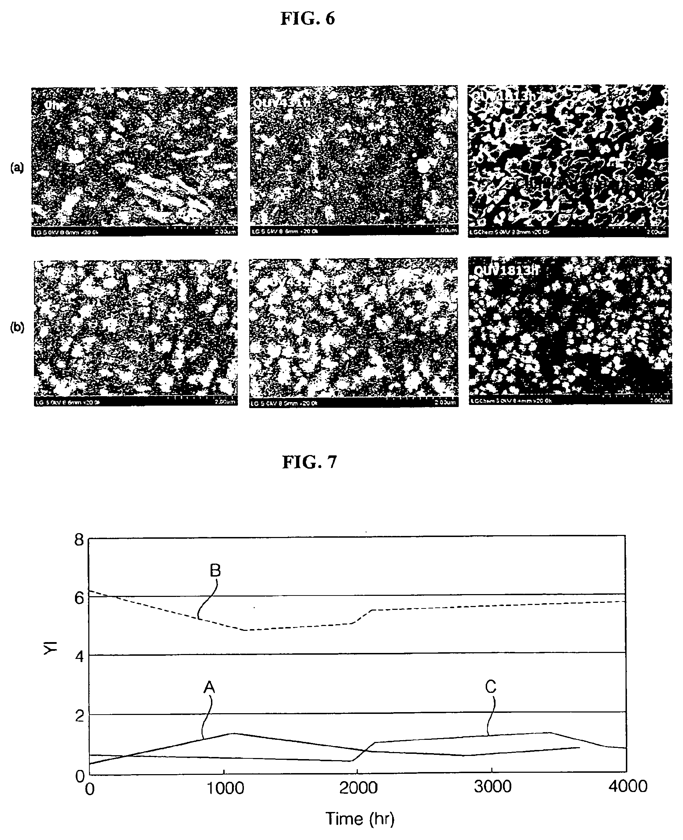

Hereinafter, properties of the rear substrate 200 will be described in greater detail. FIG. 5 is a graph illustrating UV property of the rear substrate of the solar cell module of FIG. 1. FIG. 6 depicts views showing results when the rear substrate of the solar cell module is exposed to UV. Since A, B, and C of FIG. 5 are identical to A, B, and C of FIG. 4, their description will be not repeated.

UV characteristics as illustrated in FIG. 5 are obtained by mounting samples of A, B, and C to a QUV apparatus and by measuring a yellow index YI with respect to time. According to FIG. 5, it is noticed that the YI of A is remarkably lower than those of B and C. This is because the first coating layer 220 and the second coating layer 230 include PVDF with improved ultraviolet resistance.

FIG 6 shows results of the rear substrate exposed to UV, wherein (a) of FIG. 6 shows the case of C and (b) of FIG. 6 shows the case of A. Referring to FIG. 6, (a) of FIG. 6 shows surface deterioration caused by damage due to ultraviolet rays but (b) of FIG. 6 shows the surface that is only slightly damaged by ultraviolet rays. In addition, in a case of FIG. 6B, the surface is coated during the coating process so that the dispersibility of the pigment included in the surface is generally uniform. Therefore, the rear substrate 200 according to embodiments not part of the invention manufactured by the coating process has improved ultraviolet resistance and exhibits improved reliability and high reflectivity.

FIG. 7 is a graph showing weatherproof property of the rear substrate of the solar cell module of FIG. 1.

Since 'A,' 'B,' and 'C' of FIG 7 are identical to those of FIG. 4, their description will be not repeated. In this instance, the weatherproof property is carried out at 70°C and the yellow index (YI) is measured with respect to time. As illustrated in FIG. 7, the case of A exhibits more improved weatherproof property than those of the cases of B and C.

Table 1 depicted below lists other properties of the rear substrate 200. In Table 1, A, B, and C are identical to A, B, and C of FIG. 4

In Table 1, heat shrinkage is calculated by which a mechanical direction MD and a width transversal direction TD are marked on samples having sizes of 200mm*200mm. In cases of A, B, and C, a length αprior to heating is measured, the samples are heated for 30 minutes at 150°C, lengths βafter shrinkage in the mechanical direction MD and the transversal direction TD of the respective samples, and calculation is performed using equation 1.

[Equation 1]

$$\text{Thermal shrinkage(\%)} = \frac{\alpha - \beta}{\alpha} \times 100$$

In addition, a peel strength is measured by evaluation of adhesion after elapse of 3,000 hours, and under relatively high temperature and high humidity such as a temperature of 85°C and a relative humidity of 85%. In this instance, a Tear refers to tearing out before peeling because of improved interfacial adhesion. In addition, although not listed in Table 1, under a weatherproof test conducted under the temperature 85 °C and the relative humidity 85% for about 40 days, either a bubble or a yellowing does not occur in the case of A, but do occur in the cases of B and C.

[Table 1]

|  | Unit | A | B | C |
|---|---|---|---|---|
| Peel strength | N/cm | Tear | 7 | Tear |
| Breakdown voltage | kV | >20 | >20 | >20 |
| Partial discharge | VDC | >1000 | >1000 | >1000 |
| Heat shrinkage | %(MD) | <0.1 | 0.1 | 0.7 |
|  | %(TD) | <0.1 | 0.8 | 0.5 |
| Tensile Modulus | MPa(MD) | 2,300 | 2,200 | 2,200 |
|  | MPa(TD) | 2,300 | 2,600 | 2,500 |
| Tensile Strength | MPa(MD) | 120 | 100 | 100 |
|  | MPa(TD) | 130 | 140 | 140 |

As seen from Table 1, A, that is, the rear substrate 200 according to an embodiment of the invention is better than B and C in view of a peel strength and a heat shrinkage.

In addition, Table 2 lists results of evaluating the electric properties of the solar cell module 100 that is manufactured using A. This evaluation was carried out by the Korea Institute of Energy Research.

[Table 2]

|  | 0 Hour | 500 Hours | | 1,000 Hours | | 2,000 Hours | |
|---|---|---|---|---|---|---|---|
|  | Data | Data | Drop rate | Data | Drop rate | Data | Drop rate |
| Voc | 33.2 | 33.2 | 0 | 33.2 | 0 | 33.1 | 0.3% |
| Isc | 8.71 | 8.68 | 0.3% | 8.67 | 0.5% | 8.67 | 0.5% |
| Pmax | 209.7 | 208.6 | 0.5% | 207.5 | 1.0% | 203.9 | 2.8% |
| Vmp | 26.1 | 26.0 | 0.4% | 7.97 | 1% | 7.96 | 1.1% |

As listed in Table 2, neither a short nor a defect occurred for 2,000 hours in the solar cell module 100, and particularly, Pmax is reduced to less than 5%. Therefore, it is understood that the reliability of the solar cell module 100 according to an embodiment not part of the invention is improved.

Table 3 lists evaluation results of adhesion force between the second sealing agent and the rear substrate after the weatherproof test conducted under the temperature of 85 °C and the relative humidity of 85% for about 40 days.

[Table 3]

| No. | Load(Kgf) | Completely peeled |
|-----|-----------|-------------------|
| 1 | 15.3 | Yes |
| 2 | 14 | No |
| 3 | 9.9 | No |
| 4 | 13.8 | No |
| 5 | 13.6 | Yes |

Usually, it is sufficient when adhesion force between the second sealing agent and the rear substrate is 4 Kgf or higher. Tests numbered 2 to 4 in Table 3 list forces when the rear substrate tears instead of peeling whereby the rear substrate tears before the second sealing agent and the rear substrate are separated from each other.

Nevertheless, the adhesion force between the rear substrate according to embodiments not part of the invention and the second sealing agent is greater than 9.9Kgf and has an average of 12.32 Kgf. Therefore, the adhesion force between the second sealing agent and the rear substrate is improved.

Hereinafter, embodiments not part of the invention will be described in greater detail through experimental examples. Experimental examples are provided only for illustrative purpose of the embodiments not part of the invention and the embodiments of the invention are not limited thereto.

First, influence of parts by weight of pigments included in the first coating layer 220 and the second coating layer 230 will be described with reference to experimental examples 1 to 5.

Experimental example 1

A base film made of PET with a thickness of 250µm is prepared. The first coating layer and the second coating layer that include a white pigment are formed on the upper and lower sides of the base film to a thickness of 20 µm to manufacture the rear substrate. In this instance, when total weight of the first coating layer is 100 parts by weight, the first coating layer includes the white pigment of 40 parts by weight. When a total weight of the second coating layer is 100 parts by weight, the second coating layer includes the white pigment of 40 parts by weight.

Experimental example 2

The rear substrate is manufactured by the same method as the experimental example 1 except for the first coating layer and the second coating layer including the white pigment of 50 parts by weight, respectively.

Experimental example 3

The rear substrate is manufactured by the same method as the experimental example 1 except for the first coating layer and the second coating layer including the white pigment of 60 parts by weight, respectively.

Experimental example 4

The rear substrate is manufactured by the same method as the experimental example 1 except for the first coating layer and the second coating layer including the white pigment of 70 parts by weight, respectively.

Experimental example 5

The rear substrate is manufactured by the same method as the experimental example 1 except for the first coating layer and the second coating layer including the white pigment of 80 parts by weight, respectively.

Comparative example

The rear substrate is manufactured by the same method as the experimental example 1 except for the first coating layer and the second coating layer including the white pigment of 15 parts by weight, respectively.

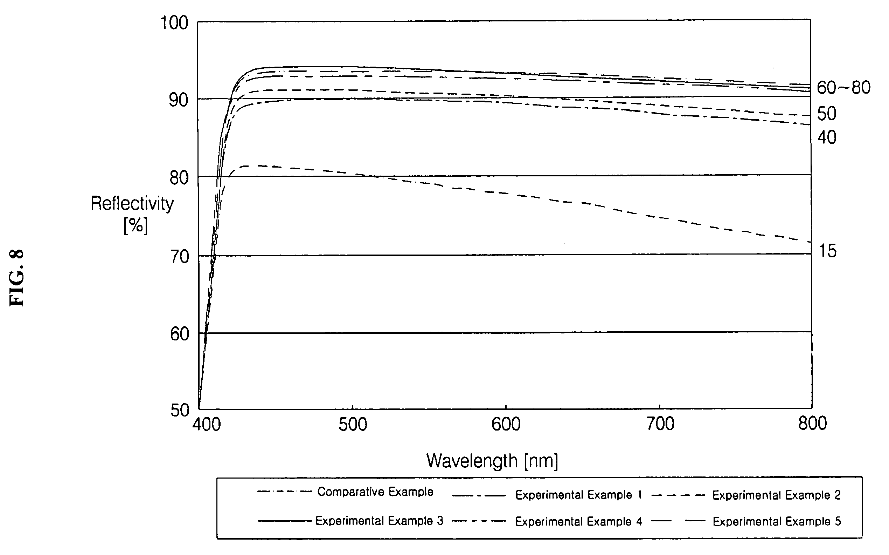

Measured results of reflectivity of the rear substrates in the experimental examples 1 to 5 and the comparative example are illustrated in FIG. 8. Referring to FIG. 8, the reflectivity of the rear substrates of the experimental examples 1 to 5 are higher than that of the rear substrate manufactured in the comparative example. That is, as seen from the experimental examples 1 to 5, when the pigment of 40 parts by weight to 80 parts by weight is included, the reflectivity at wavelengths of 450nm to 800nm is 85% or higher. Particularly, as seen from the experimental examples 3 to 5, when pigment of 60 parts by weight to 80 parts by weight is included, the reflectivity at wavelengths of 450nm to 800nm is 90% or higher, and thus, the reflectivity at wavelength of 450nm to 800nm is greatly improved.

In the experiment examples 1-5, the various embodiments not part of the invention include the first coating layer and the second coating layer having the same parts by weight of the white pigment. However, such is not required, and the parts by weight of the white pigment in the first coating layer and the second coating layer may be different in other embodiments of the invention. Further, the first coating layer and the second coating layer may have the same or different refractive indices, which also may be the same or different to that of the rear substrate. In embodiments of the invention, the refractive indices of the first coating layer, the rear substrate, and the second coating layer may be arranged to improve the reflection of solar light back to the front substrate 110.

Next, the solar cell module including the rear substrate according to example embodiments not part of the invention will be described in more detail with reference to the experimental example 6.

Experimental example 6

The rear substrate of experimental example 1, the solar cells, and the front substrate are sealed with EVA to manufacture the solar cell module. The solar cell module is put in a withstanding voltage measuring device chamber, and a withstanding voltage test is carried out at 1,000V. Then, the solar cell module is drawn out from the chamber to check the status or condition of the solar cell module. The withstanding voltage tests are also carried out at 3,000V and 6,000V.

Results of the withstanding voltage test carried out in the experiment example 6 are listed in Table 4.

[Table 4]

| Applied voltage | Result of withstanding voltage test |
|---|---|
| 1,000V | Pass |
| 3,000V | Pass |
| 6,000V | Pass |

In the solar cell module that has undergone the withstanding voltage tests, there is no problem even when the withstanding voltage tests are carried out at 1,000V, 3,000V, and 6,000V. Therefore, the solar cell module including the rear substrate according to the example embodiments not part of the invention has high durability and high reliability.

According to embodiments of the invention, since the rear substrate of the solar cell module has properties such as improved durability and weatherproof property, reliability of the solar cell module including the same may be improved.

In addition, since the rear substrate of the solar cell module includes the base film and the coating layers formed on the upper and lower sides of the base film, an adhesive layer of the rear substrate may be omitted so that a simple structure and ease of manufacture may be achieved.

Moreover, reflectivity of the rear substrate is increased due to the increased content and dispersibility of the pigment that is included in the coating layer, and the photovoltaic efficiency of the solar cell module may be improved.

While the invention has been shown and described with reference to certain preferred embodiments, it is not limited thereto, and various modifications thereto will be apparent without departing from the scope thereof.

**Claims**

**1.** A solar cell module (100) comprising:

a front substrate (110);

a rear substrate (200) facing the front substrate;

a plurality of solar cells disposed between the front substrate and the rear substrate;

a first sealing agent (131) disposed between the plurality of solar cells (150) and the front substrate (110); and

a second sealing agent (132) disposed between the plurality of solar cells (150) and the rear substrate (200), wherein the rear substrate (200) includes a base film (210) including polyethylene terephthalate, PET, having a thickness of 250 to 500 $\mu$m, a first coating layer (220) formed on an upper side of the base film, and a second coating layer (230) formed on a lower side of the base film,

wherein the first coating layer (220) is in contact with the second sealing agent (132), and the first coating layer (220) has a thickness thicker than that of the second coating layer (230), the thickness of the first coating layer (220) being 20 $\mu$m to 50 $\mu$m, and the thickness of the second coating layer (230) being at least 5 $\mu$m, and wherein the first coating layer (220) includes polyvinylidene difluoride, PVDF, and a white pigment being 40 to 80 percent by weight of the first coating layer (220), and the second coating layer (230) includes PVDF and one of the following is fulfilled for the second coating layer (230):

the second coating layer (230) includes a pigment having a type different from that of the white pigment of the first coating layer (220),

the second coating layer (230) includes a white pigment, and a content of the white pigment of the first coating layer (220) is greater than a content of the white pigment of the second coating layer, and

the second coating layer (230) does not include a pigment.

2. The solar cell module of claim 1, wherein the first and second coating layers (220, 230) further include a dispersing agent.

3. The solar cell module of claim 1, further comprising a ribbon (142) for electrically connecting the plurality of solar cells (150) to each other.

**Patentansprüche**

1. Solarzellenmodul (100) umfassend:

ein Frontsubstrat (110);

ein Rückseitensubstrat (200), das dem Frontsubstrat zugewandt ist;

eine Vielzahl von Solarzellen, die sich zwischen dem Frontsubstrat und dem Rückseitensubstrat befinden;

ein erstes Dichtungsmittel (131), das sich zwischen der Vielzahl von Solarzellen (150) und dem Frontsubstrat (110) befindet; und

ein zweites Dichtungsmittel (132), das sich zwischen der Vielzahl von Solarzellen (150) und dem Rückseitensubstrat (200) befindet,

wobei das Rückseitensubstrat (200) einen Basisfilm (210) umfasst, der Polyethylenterephthalat, PET, das eine Dicke von 250 bis 500 $\mu$m aufweist, eine erste Mantelschicht (220), die auf einer Oberseite des Basisfilms ausgebildet ist, und eine zweite Mantelschicht (230) umfasst, die auf einer Unterseite des Basisfilms ausgebildet ist,

wobei die erste Mantelschicht (220) mit dem zweiten Dichtungsmittel (132) in Kontakt steht, und die erste Mantelschicht (220) eine Dicke dicker als die Dicke der zweiten Mantelschicht (230) aufweist, wobei die Dicke der ersten Mantelschicht (220) zwischen 20 $\mu$m bis 50 $\mu$m ist, und die Dicke der zweiten Mantelschicht (230) mindestens 5 $\mu$m ist, und wobei die erste Mantelschicht (220) Polyvinylidenfluorid, PVDF, und ein weißes Pigment umfasst, das 40 bis 80 Gewichtsprozent der ersten Mantelschicht (220) ist, und die zweite Mantelschicht (230) PVDF umfasst und eines der Folgenden für die zweite Mantelschicht (230) erfüllt wird:

die zweite Mantelschicht (230) umfasst ein Pigment, das einen unterschiedlichen Typ von dem des weißen Pigments der ersten Mantelschicht (220) aufweist,

die zweite Mantelschicht (230) umfasst ein weißes Pigment, und ein Bestandteil des weißen Pigments der ersten Mantelschicht (220) ist größer als ein Bestandteil des weißen Pigments der zweiten Mantelschicht, und

die zweite Mantelschicht (230) umfasst kein Pigment.

2. Solarzellenmodul nach Anspruch 1, wobei die erste und zweite Mantelschicht (220, 230) ferner ein Dispergiermittel umfasst.

**3.** Solarzellenmodul nach Anspruch 1, ferner umfassend ein Band (142) zum elektrischen Verbinden der Vielzahl von Solarzellen (150) untereinander.

**Revendications**

**1.** Module de cellule solaire (100), comprenant :

un substrat avant (110) ;
un substrat arrière (200) faisant face au substrat avant ;
une pluralité de cellules solaires disposées entre le substrat avant et le substrat arrière ;
un premier agent d'étanchéité (131) disposé entre la pluralité de cellules solaires (150) et le substrat avant (110) ; et
un deuxième agent d'étanchéité (132) disposé entre la pluralité de cellules solaires (150) et le substrat arrière (200),
dans lequel le substrat arrière (200) comprend un film de base (210) comprenant du poly(téréphtalate d'éthylène), PET, ayant une épaisseur de 250 à 500 $\mu$m, une première couche de revêtement (220) formée sur un côté supérieur du film de base, et une deuxième couche de revêtement (230) formée sur un côté inférieur du film de base,
dans lequel la première couche de revêtement (220) est en contact avec le deuxième agent d'étanchéité (132), et la première couche de revêtement (220) a une épaisseur plus épaisse que celle de la deuxième couche de revêtement (230), l'épaisseur de la première couche de revêtement (220) étant de 20 $\mu$m à 50 $\mu$m, et l'épaisseur de la deuxième couche de revêtement (230) étant d'au moins 5 $\mu$m, et dans lequel la première couche de revêtement (220) comprend du difluorure de polyvinylidène, PVDF, et un pigment blanc étant de 40 à 80 pour cent en poids de la première couche de revêtement (220), et la deuxième couche de revêtement (230) comprend du PVDF et l'un des éléments suivants est rempli pour la deuxième couche de revêtement (230) :

la deuxième couche de revêtement (230) comprend un pigment ayant un type différent de celui du pigment blanc de la première couche de revêtement (220),
la deuxième couche de revêtement (230) comprend un pigment blanc, et une teneur en pigment blanc de la première couche de revêtement (220) est supérieure à une teneur en pigment blanc de la deuxième couche de revêtement et
la deuxième couche de revêtement (230) ne contient pas de pigment.

**2.** Module de cellule solaire selon la revendication 1, dans lequel les première et deuxième couches de revêtement (220, 230) comprennent en outre un agent dispersant.

**3.** Module de cellule solaire selon la revendication 1, comprenant en outre un ruban (142) pour connecter électriquement la pluralité de cellules solaires (150) les unes aux autres.

**FIG. 1**

**FIG. 2**

110
131
132
200

150    142

**FIG. 3**

200

T2
T1
T3

220
210
230

## FIG. 4

**FIG. 5**

## FIG. 6

## FIG. 7

**FIG. 8**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010144520 A1
- US 20100175742 A1
- US 20080216889 A1